# EUROPÄISCHE PATENTSCHRIFT

(11) **EP 3 802 219 B1**
(45) Veröffentlichungstag und Bekanntmachung des Hinweises auf die Patenterteilung: **19.04.2023**
(21) Anmeldenummer: 19728665.1
(22) Anmeldetag: 04.06.2019
(51) Int. Cl.: B60Q 5/00, B60R 21/2165, H03K 17/975

(54) **HUPENMODUL FÜR EIN FAHRZEUGLENKRAD UND BAUGRUPPE MIT EINEM FAHRER-AIRBAGMODUL UND EINEM HUPENMODUL**
HORN MODULE FOR A VEHICLE STEERING WHEEL AND ASSEMBLY COMPRISING A DRIVER AIRBAG MODULE AND A HORN MODULE
MODULE D'AVERTISSEUR SONORE POUR VOLANT DE VÉHICULE ET ENSEMBLE COMPRENANT UN MODULE DE SAC GONFLABLE DE CONDUCTEUR ET UN MODULE AVERTISSEUR SONORE

(30) Priorität: 07.06.2018 DE 202018103191 U
(43) Veröffentlichungstag der Anmeldung: 14.04.2021
(73) Patentinhaber: Dalphi Metal España, S.A., 36213 Vigo (ES)
(72) Erfinder: BAÑA CASTRO, Ramón, 36208 Vigo (ES); PÉREZ BLANCO, Mónica, 36209 Vigo (ES); BALBÁS CALVO, Alexandra, 36210 Vigo (ES)
(74) Vertreter: ZF Patentabteilung - DIPS
(86) Internationale Anmeldenummer: PCT/EP2019/064425
(87) Internationale Veröffentlichungsnummer: WO 2019/233983

(56) Entgegenhaltungen:
- EP-A1- 1 661 773
- EP-A2- 1 481 848
- EP-A2- 1 623 886
- CN-Y- 2 666 738
- DE-A1-102009 016 744
- DE-A1-102016 219 844
- US-A- 5 942 815
- US-A1- 2011 050 251

## Beschreibung

Die Erfindung betrifft ein Hupenmodul für ein Fahrzeuglenkrad. Die Erfindung betrifft ferner eine Baugruppe für ein Fahrzeuglenkrad mit einem Fahrer-Airbagmodul und einem daran angebrachten Hupenmodul.

Seit der serienmäßigen Einführung von Airbagmodulen im Lenkrad ist es ein Ziel, die Anordnung und Integration der Hupenschaltung zu verbessern. Ein weit verbreitetes Konzept sieht vor, das Airbagmodul schwimmend, als sogenanntes "Floating Module", einzubauen, wobei zur Betätigung der Hupe das gesamte Airbagmodul in die Lenkradnabe hineingedrückt wird. Hierdurch wird generell ein Hupenschaltkreis geschlossen, wobei sich ein Teil eines Schalters am Airbagmodul und der andere Teil an der Lenkradnabe befindet. Bei geschlossenem Hupenschaltkreis fließt ein Strom, und eine Auswerteschaltung bewirkt die Auslösung eines Hupsignals.

Gemäß einem anderen Konzept wird nur die dem Fahrer zugewandte Abdecckappe des Airbagmoduls relativ zu den stationären Bauteilen des Airbagmoduls bewegt ("Floating Cover"). Bei der in der DE 20 2005 008 374 U1 vorgeschlagenen Lösung weist der Hupenkontakt ein zwischen dem zentralen Abschnitt der Abdeckkappe und einem stationären Bauteil des Airbagmoduls angeordnetes Kontaktelement auf, sodass durch ein Niederdrücken des zentralen Abschnitts der Abdeckkappe um einen bestimmten Hub der Hupenkontakt geschlossen wird.

Es ist auch allgemein bekannt, anstelle eines mechanisch schließenden Kontakts ein berührungslos arbeitendes Sensorsystem zur Erfassung eines Hubs vorzusehen. Aus der EP 2 426 012 A1 ist eine Lenkanordnung mit einem kapazitiven Sensor als Schaltelement zur Auslösung eines Hupsignals bekannt. Dabei bilden eine an einer beweglichen Betätigungsfläche und eine am Lenkradkörper fest angeordnete elektrisch leitende Fläche einen Kondensator. Bei manueller Ausübung eines Drucks auf die Betätigungsfläche wird der Abstand zur gegenüberliegenden elektrisch leitenden Fläche verkürzt. Anhand der daraus resultierenden Kapazitätsänderung wird das Schaltsignal zum Auslösen des Hupsignals erzeugt.

Die EP 1 661 773 A1 offenbart ein Fahrzeuglenkrad mit einem Airbagmodul, dass zur Erzeugung eines Hupsignals um einen axialen Hub niedergedrückt werden kann, wobei ein berührungslos arbeitendes Sensorsystem zur Erfassung dieses Hubs vorgesehen ist, welches beispielsweise auf einem kapazitiven Messsystems beruht.

Darüber hinaus ist in der DE 10 2009 016 744 A1 bereits eine Hupenaktivierungseinrichtung beschrieben, mit einem Betätigungselement und einem Hupenschalter, der mit dem Betätigungselement gekoppelt ist und in einem Aktivierungszustand einen Hupenschaltkreis schließt, wobei zumindest ein Kontakt des Hupenschalters an einem Wickelelement des Lenkrads angeordnet ist.

Aufgabe der Erfindung ist es, gegenüber den bekannten Lösungen ein zuverlässiges, platzsparendes und kostengünstiges Hupenmodul für ein Kraftfahrzeug zu schaffen.

Gelöst wird diese Aufgabe durch ein Hupenmodul mit den Merkmalen des Anspruchs 1 sowie durch eine Baugruppe mit den Merkmalen des Anspruchs 16. Vorteilhafte und zweckmäßige Ausgestaltungen des erfindungsgemäßen Hupenmoduls und der erfindungsgemäßen Baugruppe sind in den zugehörigen Unteransprüchen angegeben.

Das erfindungsgemäße Hupenmodul für ein Fahrzeuglenkrad umfasst wenigstens eine kapazitive Sensoreinheit zur Erfassung einer Hupenbetätigung sowie eine Elektronikeinheit zur Signalverarbeitung und -auswertung und zur Auslösung eines Hupsignals. Die Sensoreinheit weist eine erste Elektrode und eine gegenüberliegende zweite Elektrode auf, die durch Betätigung eines Auslöseelements in einer Verschieberichtung so relativ zueinander verschiebbar sind, dass sich dadurch das Ausmaß der Überlappung der Elektroden verändert.

Die Erfindung beruht zunächst auf der grundlegenden Erkenntnis, dass eine Fahrzeughupe, die nicht durch mechanisches Schließen von Kontakten ausgelöst wird, sondern in Abhängigkeit des von einem Sensorsystem erfassten Hubs eines Auslöseelements, einige wesentliche Vorteile hat. Insbesondere werden keine verschleißanfälligen Kontakte benötigt, deren Funktion durch Abnutzung oder Alterung (z.B. Korrosion, Elektroerosion) beeinträchtigt werden kann. Außerdem erlaubt ein berührungsloses Sensorsystem im Vergleich zu einem auf mechanischen Kontakten basierenden System, das lediglich einen geschlossenen Kontakt erkennen kann, eine viel genauere Erfassung eines Hubs.

Beim erfindungsgemäßen Hupenmodul kommt wenigstens eine kapazitive Sensoreinheit zum Einsatz, die jedoch nicht auf dem bekannten Prinzip der Kapazitätsänderung durch Annäherung von zwei Elektroden basiert. Stattdessen kommt ein Aufbau zum Einsatz, bei dem einander gegenüberliegende Elektroden durch das Betätigen des Auslöseelements relativ zueinander verschoben werden, sodass sich das Ausmaß deren Überlappung verändert. Mit der Änderung der Überdeckung der Elektroden ändert sich auch die Kapazität zwischen den beiden Elektroden. Die Messung dieser Kapazitätsänderung erlaubt eine zuverlässige und präzise Erfassung einer Hupbewegung und eine darauf basierende Auslösung des Hupsignals.

Gemäß dem bevorzugten Aufbau des erfindungsgemäßen Hupenmoduls haben die beiden Elektroden einander gegenüberliegende Flächen, die parallel zur Verschieberichtung orientiert sind. Eine der Elektroden kann dann an das Auslöseelement gekoppelt werden, um durch dessen Verschiebung die gewünschte Änderung des Überlappungsgrads gegenüber der feststehenden anderen Elektrode zu erreichen. Vorzugsweise bleibt bei einer solchen Verschiebung der Elektroden ihr Abstand voneinander, genauer gesagt der Abstand der Elektrodenflächen in einer zur Verschieberichtung senkrechten Richtung, gleich. Da bei einem Plattenkondensator die Kapazität indirekt proportional zum Abstand der Flächen ist, muss ein entsprechender Einfluss auf die Kapazitätsänderung nicht berücksichtigt werden, wenn bei der Verschiebung ein gleichbleibender Abstand der Elektrodenflächen gewährleistet ist.

Die relative Verschiebung der Elektroden sollte einen möglichst großen Effekt auf die Kapazität haben, um eine möglichst robuste und zuverlässige Detektion der durch die Verschiebung bewirkten Kapazitätsänderung sicherzustellen. Dies kann dadurch erreicht werden, dass ein vom Auslöseelement zurücklegbarer Verschiebeweg begrenzt ist, und dass die Elektroden relativ zueinander so angeordnet sind, dass sie sich bei maximaler Verschiebung maximal überlappen. Das bedeutet, dass der Verschiebeweg ein definiertes Ende hat, bei dessen Erreichen die Kapazität der Elektroden maximal ist. Ein solches Ansteigen der Kapazität bis zu einem Maximalwert ist messtechnisch gut erfassbar. Grundsätzlich kann natürlich auch die umgekehrte Variante gewählt werden, d. h. die Überlappung und damit die Kapazität sind in der Ausgangslage maximal und verringern sich durch die Verschiebung.

Erfindungsgemäß weist die kapazitive Sensoreinheit einen Rahmen und einen im Rahmen verschiebbar gelagerten Schlitten auf, der am Auslöseelement angebracht ist. Die erste Elektrode ist am Rahmen und die zweite Elektrode am Schlitten angebracht, sodass eine Bewegung des Schlittens im Rahmen die gewünschte relative Verschiebung der Elektroden bewirkt.

"Angebracht" bedeutet in diesem speziellen Zusammenhang, aber auch allgemein in der weiteren Beschreibung, eine direkte Befestigung oder eine starre Kopplung (indirekte Verbindung mit dazwischenliegenden Elementen) der jeweiligen Komponenten, sodass diese relativ zueinander unbeweglich sind.

Grundsätzlich ist es ausreichend, dass nur die erste Elektrode mit der Elektronikeinheit elektrisch verbunden ist. Zur Messung der Kapazität des durch die beiden Elektroden gebildeten Kondensators und für das Auf- und Entladen des Kondensators durch entsprechende Komponenten der Elektronikeinheit ist nur eine elektrische Anbindung der ersten Elektrode erforderlich, die zur Vermeidung einer mechanischen Beanspruchung der Kontakte bzw. Leitungen vorzugsweise feststehend ist.

Um möglichst störungsfreie, reproduzierbare Messergebnisse zu erhalten, empfiehlt sich eine im Wesentlichen plattenförmige Ausbildung der ersten Elektrode mit einer elektrisch leitenden Sensorfläche, die von einem elektrisch leitenden Abschirmrahmen umgeben ist. Der Abschirmrahmen kann auf Masse liegen oder auf ein definiertes Potential gelegt werden.

Die Sensorfläche und der Abschirmrahmen sind zur gegenseitigen elektrischen Isolierung vorzugsweise auf einem nicht leitfähigen Träger aufgebracht.

Im Hinblick auf eine Erhöhung der Robustheit und Zuverlässigkeit der Detektion einer Verschiebung des Auslöseelements des Hupenmoduls und zur Sicherung gegen den Ausfall einer kapazitiven Sensoreinheit ist es sinnvoll, mehrere voneinander beabstandete kapazitive Sensoreinheiten vorzusehen.

Bei der bevorzugten Ausführungsform des erfindungsgemäßen Hupenmoduls sind die kapazitiven Sensoreinheiten aus Sicht des Fahrers bezogen auf die Verschieberichtung in der 3-Uhr, 6-Uhr und 9-Uhr-Position angeordnet.

Eine erhebliche Vereinfachung der Montage des Hupenmoduls wird mit einer Ausführungsform erreicht, bei der die ersten Elektroden der kapazitiven Sensoreinheiten über wenigstens ein flexibles Band, das mehrere elektrische Leitungen trägt, mechanisch miteinander verbunden sind. Die ersten Elektroden können somit als vorgefertigte Baueinheit in Form eines "Sensorgürtels" bereitgestellt werden, was nicht nur eine leichtere Handhabung bei der Montage ermöglicht, sondern auch logistische Vorteile hat. Dank des flexiblen Bands kann jede erste Elektrode an ihrem vorgesehenen Platz fixiert werden, ohne dass die anderen ersten Elektroden verloren gehen. Gleichzeitig stellt das flexible Band die für die Abtastung aller ersten Elektroden notwendigen elektrischen Leitungen zur Verfügung.

Insbesondere stellen die elektrischen Leitungen des flexiblen Bands eine elektrische Verbindung zwischen den Sensorflächen der ersten Elektroden und der Elektronikeinheit sowie vorzugsweise auch zwischen den Abschirmrahmen und der Elektronikeinheit her.

Um Beschädigungen bei der elektrischen Anbindung des Sensorgürtels weitestgehend auszuschließen, ist es vorteilhaft, dass die empfindlichen Kontaktstellen, in denen Leitungen des flexiblen Bands enden, in einem Nullkraftsockel der Elektronikeinheit aufgenommen sind.

Eine mögliche Ausgestaltung der Elektronikeinheit sieht wenigstens einen mit der kapazitiven Sensoreinheit verbundenen Kapazität/-Digital-Wandler und einen Mikrocontroller zur Auswertung der vom Kapazität/-Digital-Wandler bereitgestellten Werte vor. Vorzugsweise ist der Mikrocontroller noch mit einem Prozessorüberwachungselement und einem LIN-Transceiver mit integriertem Spannungsregler verbunden.

Es gibt grundsätzlich viele verschiedene Möglichkeiten, die Änderung der Kapazität zwischen den Elektroden messtechnisch zu erfassen. Geeignete Messverfahren, die mithilfe integrierter Schaltungsbauteile realisierbar sind, basieren beispielsweise auf Resonanzfrequenzverschiebung, Frequenzmodulation, Amplitudenmodulation, Ladezeitmessung, Zeitverzögerungsmessung, Tastverhältnis etc.

Bevorzugt ist die Elektronikeinheit zur Durchführung eines Auswertungsverfahrens eingerichtet, das auf einer Zählung von Takten und einem Vergleich mit einem Referenzzählwert basiert.

Für die Durchführung eines bevorzugten Messverfahrens, das eine Auswertung nach der oben beschriebenen Art erlaubt, weist die Elektronikeinheit eine mit wenigstens einer der Elektroden verbundene (Konstant-)stromquelle zum Aufladen eines durch die Elektroden gebildeten Kondensators, einen Zähler zum Zählen von Takten, einen Komparator zum Vergleichen der Kondensatorspannung mit einem Referenzschwellenwert, einen durch den Ausgangspegel des Komparators steuerbaren Schalter zum Entladen des Kondensators und einen Speicher mit einem hinterlegten Referenzzählwert auf.

Die Elektronikeinheit ist dann vorzugsweise so eingerichtet ist, dass in einem kontinuierlich wiederholten Prozess die Konstantstromquelle den Kondensator auflädt, der Komparator die Kondensatorspannung fortwährend mit einem Referenzschwellenwert vergleicht, ein Zähler die Takte bis zum Erreichen des Referenzschwellenwerts zählt, bei Erreichen des Referenzschwellenwerts der Schalter einen Schaltkreis zum Entladen des Kondensators schließt und der Zähler zurückgesetzt wird.

Für die Auswertung der gezählten Takte ist die Elektronikeinheit bevorzugt so eingerichtet, dass die Anzahl der bis zum Erreichen des Referenzschwellenwerts benötigten Takte mit einem hinterlegten Referenzzählwert verglichen wird, wobei bei einem Überschreiten oder Unterschreiten des Referenzzählwerts ein Hupsignal ausgelöst wird.

Die Erfindung schafft auch eine Baugruppe für ein Fahrzeuglenkrad, mit einem Fahrer-Airbagmodul und einem daran angebrachten erfindungsgemäßen Hupenmodul. Bei der erfindungsgemäßen Baugruppe kann das Fahrer-Airbagmodul grundsätzlich gemäß dem Floating-Module-Konzept als komplett verschiebbares Modul oder mit feststehendem Airbagmodul-Gehäuse und verschiebbarer Abdeckung gemäß dem Floating-Cover-Konzept ausgebildet sein.

Im bevorzugten letzteren Fall ist die erste Elektrode vorzugsweise an einem (relativ zu einem Lenkrad) feststehenden Gehäuse des Fahrer-Airbagmoduls und die zweite Elektrode an der als Auslöseelement dienenden dazu verschiebbaren Abdeckung des Fahrer-Airbagmoduls angebracht.

Konkret kann die die erste Elektrode an einer im Wesentlichen parallel zur Verschieberichtung verlaufenden Seitenwand des Airbagmodul-Gehäuses angebracht sein.

Dazu passend kann die zweite Elektrode an einer im Wesentlichen parallel zur Verschieberichtung verlaufenden Seitenwand der Abdeckung angebracht sein.

Wie bereits erwähnt weist die kapazitive Sensoreinheit gemäß der Erfindung einen Rahmen und einen im Rahmen verschiebbar gelagerten Schlitten auf, der am Auslöseelement angebracht ist, wobei die erste Elektrode am Rahmen und die zweite Elektrode am Schlitten angebracht ist, sodass eine Bewegung des Schlittens im Rahmen die gewünschte relative Verschiebung der Elektroden bewirkt. Bei einem solchen Aufbau der kapazitiven Sensoreinheit empfiehlt es sich, den Rahmen der kapazitiven Sensoreinheit am Airbagmodul-Gehäuse und den darin beweglichen Schlitten an der Abdeckung anzubringen.

Gemäß einem besonders vorteilhaften Aspekt der Erfindung bildet der im Rahmen verschiebbare Schlitten zusammen mit wenigstens einem Federelement ein Lager für die Abdeckung, sodass die Abdeckung gegen den Widerstand des Federelements niedergedrückt werden kann. Die kapazitive Sensoreinheit hat demnach eine Doppelfunktion, sodass Bauteile für ein separates Lager eingespart werden können.

Bei einer bevorzugten Ausführungsform des erfindungsgemäßen Hupenmoduls ist vorgesehen, dass eine Druckfläche des Schlittens und eine Gegendruckstelle der Abdeckung nur im Auslösefall miteinander in Kontakt stehen und/ oder, dass die Gegendruckstelle der Abdeckung und die Druckfläche des Schlittens im Ruhezustand voneinander beabstandet angeordnet sind.

Bei einer bevorzugten Ausführungsform des erfindungsgemäßen Hupenmoduls ist vorgesehen, dass eine Druckfläche des Schlittens, die im Auslösefall mit einer Gegendruckstelle der Abdeckung in Kontakt steht, zumindest zur Montage von Abdeckung und Airbagmodul-Gehäuse relativ beweglich zum Schlitten ausgebildet ist.

Die Elektronikeinheit des Hupenmoduls ist zweckmäßigerweise am Airbagmodul angebracht, insbesondere auf einer vom Fahrer abgewandten Unterseite des Airbagmodul-Gehäuses.

Im Hinblick auf eine weitere Einsparung von Bauteilen und Reduzierung der Montageschritte sieht die Erfindung gemäß einem vorteilhaften Aspekt vor, dass zur Befestigung der Elektronikeinheit dieselben Befestigungsmittel wie für die Befestigung einer Airbag-Einheit im Airbagmodul-Gehäuse verwendet werden.

Gemäß einem weiteren Aspekt der Erfindung wird ein Lenkrad mit einem daran angebrachten Hupenmodul vorgeschlagen, wobei das Hupenmodul eines oder mehrere der zuvor beschriebenen Merkmale aufweist.

Weitere Merkmale und Vorteile der Erfindung ergeben sich aus der nachfolgenden Beschreibung und aus den beigefügten Zeichnungen, auf die Bezug genommen wird. In den Zeichnungen zeigen:
- Figur 1 eine vereinfachte Prinzipskizze des erfindungsgemäßen Hupenmoduls;
- Figur 2 eine vereinfachte perspektivische Ansicht zweier Elektroden einer kapazitiven Sensoreinheit des erfindungsgemäßen Hupenmoduls;
- Figur 3 eine erste perspektivische Vorderansicht eines Sensorgürtels des erfindungsgemäßen Hupenmoduls;
- Figur 4 eine zweite perspektivische Rückansicht des Sensorgürtels aus Figur 3;
- Figur 5 eine Draufsicht auf ein Detail des Sensorgürtels aus Figur 3;
- Figur 6 eine seitliche Schnittansicht eines Details des Sensorgürtels aus Figur 3;
- Figur 7 eine perspektivische Ansicht eines Sensorgürtels und einer Elektronikeinheit des erfindungsgemäßen Hupenmoduls;
- Figur 8 eine perspektivische Vorderansicht einer erfindungsgemäßen Baugruppe mit dem erfindungsgemäßen Hupenmodul und einem Airbagmodul;
- Figur 9 eine perspektivische Rückansicht der erfindungsgemäßen Baugruppe aus Figur 8 ohne Abdeckung;
- Figur 10 eine perspektivische Ansicht einer kapazitiven Sensoreinheit des erfindungsgemäßen Hupenmoduls;
- Figur 11 einzelne Teile der kapazitiven Sensoreinheit aus Figur 10;
- Figur 12 eine perspektivische Ansicht s des erfindungsgemäßen Hupenmoduls während des Zusammenfügen;
- Figur 13 eine weitere perspektivische Ansicht des erfindungsgemäßen Hupenmoduls nach dem Zusammenfügen;
- Figur 14 eine Zusammenstellung der elektronischen Komponenten des erfindungsgemäßen Hupenmoduls;
- Figur 15 den prinzipiellen Funktionsablauf des erfindungsgemäßen Hupenmoduls;
- Figur 16 eine Prinzipdarstellung der Auswertung der Messwerte beim erfindungsgemäßen Hupenmodul;
- Figur 17 den zeitlichen Verlauf der Spannungssignale bei nicht betätigtem und bei betätigtem Auslöseelement; und
- Figur 18 ein Taktzählungsdiagramm zur Veranschaulichung der Auswertung der Messwerte.

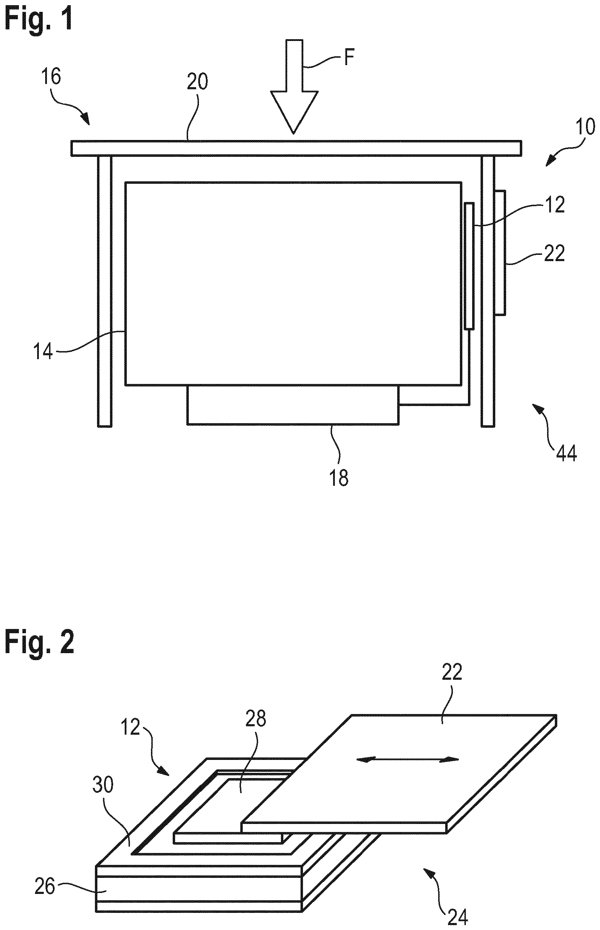

In Figur 1 ist das erfindungsgemäße Hupenmodul 10 für ein Fahrzeuglenkrad in einer Prinzipskizze dargestellt. Eine erste Elektrode 12, hier als Messelektrode bezeichnet, ist seitlich an einem Gehäuse 14 eines an bzw. in einem Lenkrad bringbaren bzw. untergebrachten Fahrer-Airbagmoduls 16 fest angebracht, d. h. die Messelektrode 12 ist relativ zum Airbagmodul-Gehäuse 14 unbeweglich. Die Messelektrode 12 ist mit einer ebenfalls am Airbagmodul-Gehäuse 14 angebrachten Elektronikeinheit 18 verbunden. Ein Auslöseelement in Form einer Abdeckung 20, die Teil des Fahrer-Airbagmoduls 16 bzw. des Fahrzeuglenkrads ist, kann vom Fahrer zum Auslösen eines Hupsignals in bekannter Weise in einer Verschieberichtung F niedergedrückt werden, die (im Wesentlichen) parallel zur Drehachse des Fahrzeuglenkrads (Lenkradachse) ist. An der Abdeckung 20 ist ein elektrischer Leiter angeordnet, hier bevorzugt in Form einer dünnen Metallplatte, der eine zweite Elektrode 22 bildet, welche hier zur leichteren Unterscheidung als Kondensatorelektrode bezeichnet wird. Die Kondensatorelektrode 22 ist in der hier schematisch dargestellten Ausführungsform an einer Seite der Abdeckung 20 fest angebracht, die parallel zu der Seite des Airbagmodul-Gehäuses 14 ist, an der die Messelektrode 12 angebracht ist. Dies kann, wie hier gezeigt die Außenseite der Abdeckung 20 sein, jedoch ist eine Anbringung auf der Innenseite ebenfalls denkbar.

Die beiden Elektroden 12, 22 haben in radialer Richtung (bezogen auf die Lenkradachse bzw. die Verschieberichtung F) einen geringen Abstand voneinander. Bezogen auf die Verschieberichtung F sind die beiden Elektroden 12, 22 relativ zueinander so positioniert, dass sie sich zumindest teilweise überlappen, d. h. dass sich die einander zugewandten Flächen der Elektroden 12, 22 zumindest teilweise überdecken. Wenn die Abdeckung 20 mit der daran angebrachten Kondensatorelektrode 22 in der Verschieberichtung F niedergedrückt wird, bleibt ihr radialer Abstand zur feststehenden Messelektrode 12 am Airbagmodul-Gehäuse 14 gleich, wogegen sich in der Verschieberichtung F ihre relative Position zur Messelektrode 12 und damit das Ausmaß der Überlappung verändert.

Die beiden Elektroden 12, 22 sind die wesentlichen Bestandteile einer kapazitiven Sensoreinheit 24. Die beschriebene Veränderung der Position der Kondensatorelektrode 22 relativ zur Messelektrode 12 bewirkt eine messbare Veränderung der Kapazität des durch die beiden Elektroden 12, 22 gebildeten Kondensators. Diese Kapazitätsänderung kann durch eine geeignete Auswertung, die später noch im Detail beschrieben wird, zur Erkennung einer Hupbewegung und zum Auslösen des Hupsignals verwendet werden.

Die beiden Elektroden 12, 22 der kapazitiven Sensoreinheit 24 sind in Figur 2 separat und in vereinfachter Form dargestellt. Während die Kondensatorelektrode 22 hier als einfache Metallplatte ausgebildet ist, hat die Messelektrode 12 einen komplexeren Aufbau. Sie ist grundsätzlich ebenfalls plattenförmig, weist aber einen nicht elektrisch leitenden Träger 26 auf, auf dem eine sensible Sensorfläche 28 angeordnet ist. Die Sensorfläche 28 ist in einem kleinen Abstand von einem elektrisch leitenden Abschirmrahmen 30 umgeben, der zur passiven oder aktiven Abschirmung der Sensorfläche 28 dient. Der Träger 26 besteht vorteilhafter Weise vollständig oder teilweise aus einem schwer entflammbaren und flammenhemmenden FR4-Verbundwerkstoff aus Epoxidharz und Glasfasergewebe.

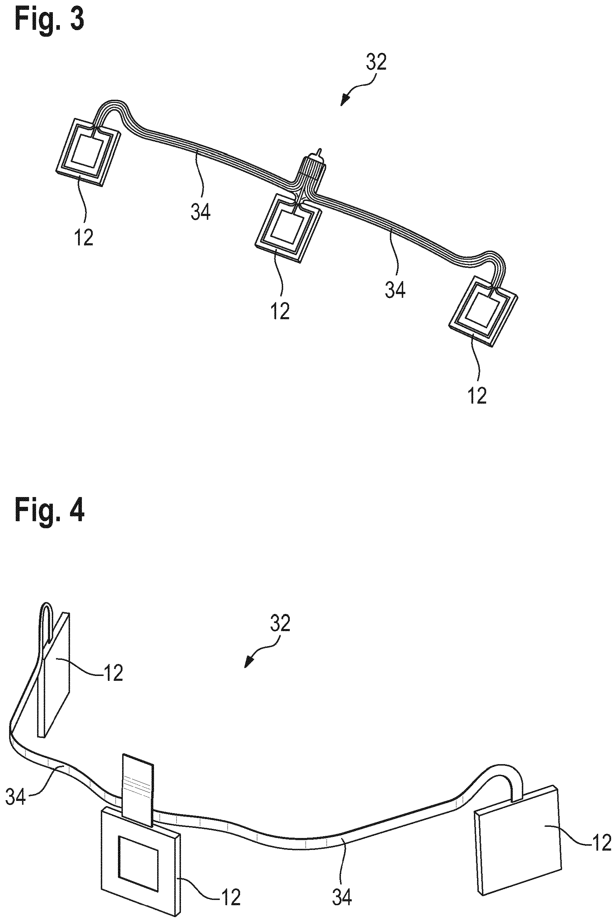

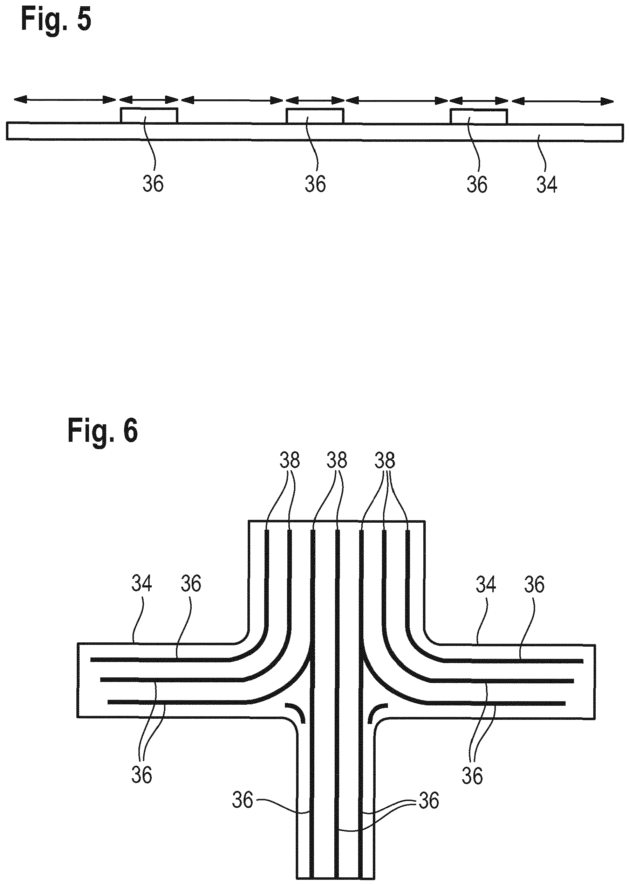

In den Figuren 3 und 4 ist ein Verbund mehrerer, hier drei, Messelektroden 12 dargestellt, der nachfolgend als Sensorgürtel 32 bezeichnet wird. Zwei äußere Messelektroden 12 sind jeweils durch ein flexibles Band 34 mit einer mittleren Messelektrode 12 verbunden. Auf dem flexiblen Band 34 sind mehrere voneinander beabstandete elektrische Leitungen 36 in Form von Leiterbahnen angeordnet, wie aus der Detailansicht der Figur 5 hervorgeht. Eine der elektrischen Leitungen 36 ist jeweils mit der Sensorfläche 28 und eine andere elektrische Leitung 36 jeweils mit dem Abschirmrahmen 30 der entsprechenden Messelektrode 12 verbunden. In der hier gezeigten Ausführungsform weist der Sensorgürtel 32 insgesamt 3 Messelektroden 12 auf; in alternativen Ausführungsformen können auch weniger (insbesondere eine oder zwei) oder auch mehr (insbesondere vier, fünf, oder sechs) Messelektroden 12 vorgesehen sein. Alternativ zur Anordnung der Leitungen 36 als Leiterbahnen eines flexiblen Bandes können diese auch als flexible Drahtleitungen (Litze bzw. Litzen) ausgebildet sein.

Figur 6 zeigt die Anbindungsstelle für eine, hier die mittlere der, Messelektroden 12. Die oberhalb dieser (mittleren) Messelektrode 12 zusammengeführten, aber (vorzugsweise, insbesondere teilweise weiterhin getrennten) elektrischen Leitungen 36 enden in Kontaktstellen 38, die zur Einführung in einen Nullkraftsockel (ZIF, zero insertion force) vorgesehen sind und damit den einen Teil einer Steckverbindung bilden.

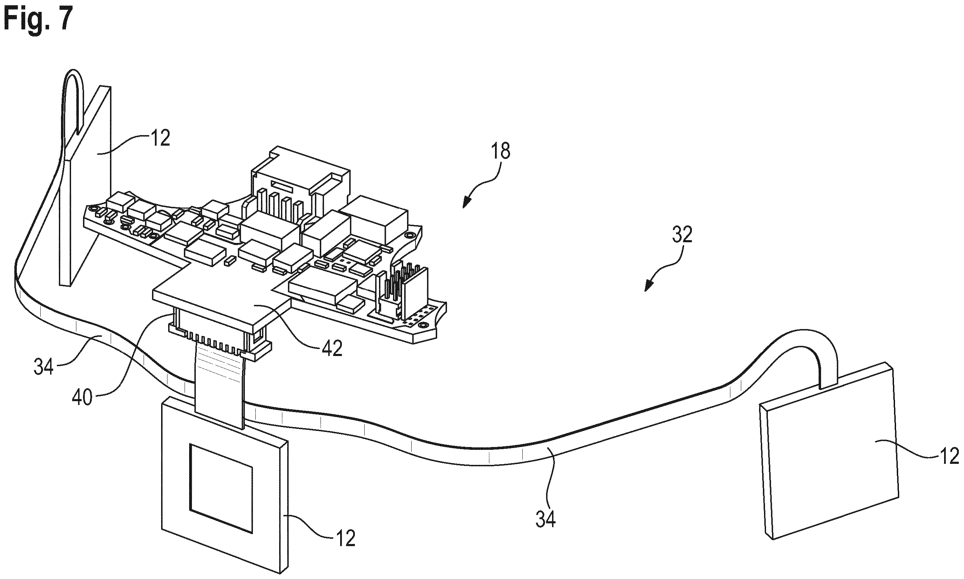

In Figur 7 ist die ganze Steckverbindung zu sehen. Die Kontaktstellen 38 des Sensorgürtels 32 sind in einem Nullkraftsockel 40 fixiert, der auf einer Leiterplatte 42 befestigt ist. Die Leiterplatte 42 mit ihren darauf angeordneten elektronischen Bauelementen bildet die Elektronikeinheit 18, die später noch genauer erläutert wird. Alternativ können die Leitungen auch direkt (ohne Steckverbindung) an der Elektronikeinheit 18, insbesondere der Leiterplatte 42 (z.B. durch Verlöten) angebunden sein.

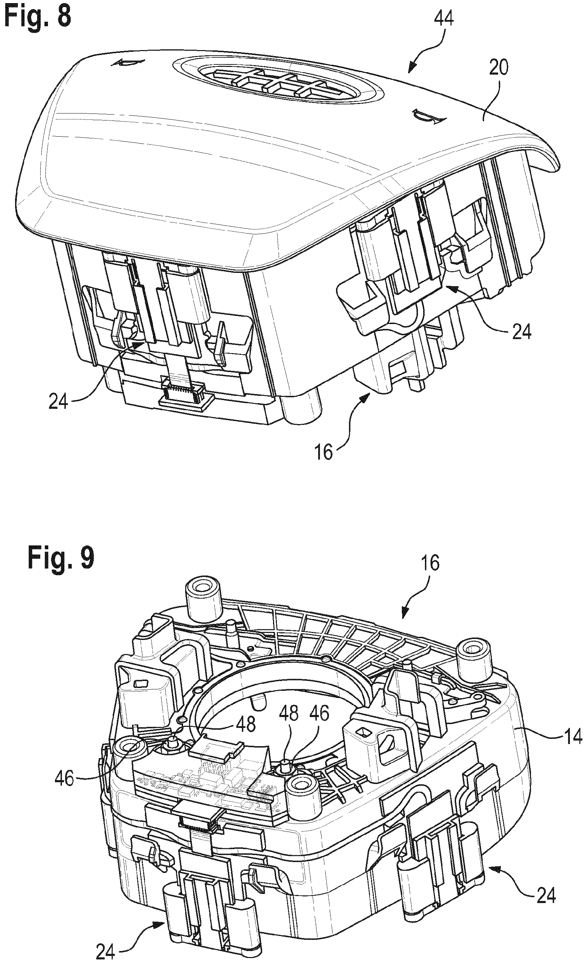

Figur 8 zeigt das gesamte Hupenmodul 10, das mit dem Fahrer-Airbagmodul 16 eine Baugruppe 44 bildet, die zum Einbau in ein Fahrzeuglenkrad vorgesehen ist. Wie in der rückseitigen Ansicht der Figur 9 (ohne Abdeckung 20) zu erkennen ist, ist die Elektronikeinheit 18 des Hupenmoduls 10 auf der Unterseite des Airbagmodul-Gehäuses 14 befestigt. Für die Befestigung werden in der hier gezeigten Ausführungsform Muttern 46 verwendet, die gleichzeitig zur Befestigung einer im Airbagmodul-Gehäuse 14 untergebrachten (in den Figuren 8 und 9 nicht gezeigten) Airbag-Einheit vorgesehen sind. Die Airbag-Einheit weist Schraubbolzen 48 auf, die durch passende Löcher im Airbagmodul-Gehäuse 14 ragen und von der Gehäuseunterseite her mit den Muttern 46 gesichert werden. Die Leiterplatte 42 der Elektronikeinheit 18 wird dabei zwischen den Muttern 46 und dem Airbagmodul-Gehäuse 14 eingeklemmt. Hierfür weist die Leiterplatte 42 zwei zu den Löchern im Airbagmodul-Gehäuse 14 passende Löcher auf, die ebenfalls von den Schraubbolzen 48 durchdrungen werden.

Entsprechend dem zuvor beschriebenen Verbund der drei Messelektroden 12 umfasst das Hupenmodul 10 drei kapazitive Sensoreinheiten 24. In Draufsicht auf das Hupenmodul 10 (d. h. aus Sicht des Fahrers entlang der Lenkradachse auf die im Fahrzeuglenkrad eingebaute Modul-Baugruppe 44) sind die kapazitiven Sensoreinheiten 24 bei der dargestellten Ausführungsform in der 3-Uhr, 6-Uhr und 9-Uhr-Position am Airbagmodul-Gehäuse 14 angebracht - mit Ausnahme der Kondensatorelektroden 22 der kapazitiven Sensoreinheiten 24, die in entsprechender Anordnung an der Abdeckung 20 des Fahrer-Airbagmoduls 16 angebracht sind. In einer alternativen Ausführungsform kann eine weitere Sensoreinheit 24 sowie eine weitere, zugehörige Kondensatorelektrode 22 (z.B. an der 12-Uhr Position) angeordnet sein. Bei insgesamt jeweils drei Sensoreinheiten/ Kondensatorelektroden kann (insbesondere bei runden Modulgehäusen) eine Anordnung im jeweiligen Abstand von 120° zueinander vorgesehen sein (an der 2-Uhr, 6-Uhr und 10-Uhr-Position bzw. an der 12-Uhr, 4-Uhr und 8-Uhr-Position)

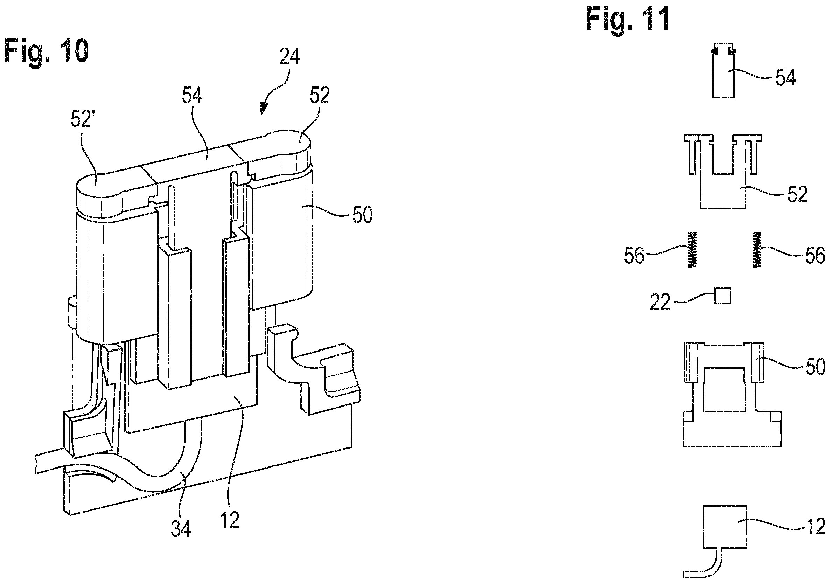

Der Aufbau der kapazitiven Sensoreinheiten 24 wird nachfolgend anhand der Figuren 10 und 11 genauer beschrieben. Die in Figur 10 im zusammengebauten Zustand gezeigte kapazitive Sensoreinheit 24 ist im Wesentlichen vorzugsweise aus den in Figur 11 einzeln gezeigten Komponenten gebildet. Diese Komponenten sind: ein Rahmen 50, ein im Rahmen 50 verschiebbar gelagerter Schlitten 52, ein Schlittenteil 54, zwei Federelemente 56 in Form von Schraubenfedern sowie die Messelektrode 12 und die Kondensatorelektrode 22.

Die Messelektrode 12 ist fest am Rahmen 50 angebracht, der wiederum fest mit dem Airbagmodul-Gehäuse 14 verbunden oder einstückig mit diesem ausgebildet ist. Die Kondensatorelektrode 22 ist fest am Schlitten 52 angebracht.

Der Schlitten 52 kann gemäß einer möglichen Ausführungsform (vorzugsweise fest) mit der Abdeckung 20 verbindbar bzw. verbunden sein.

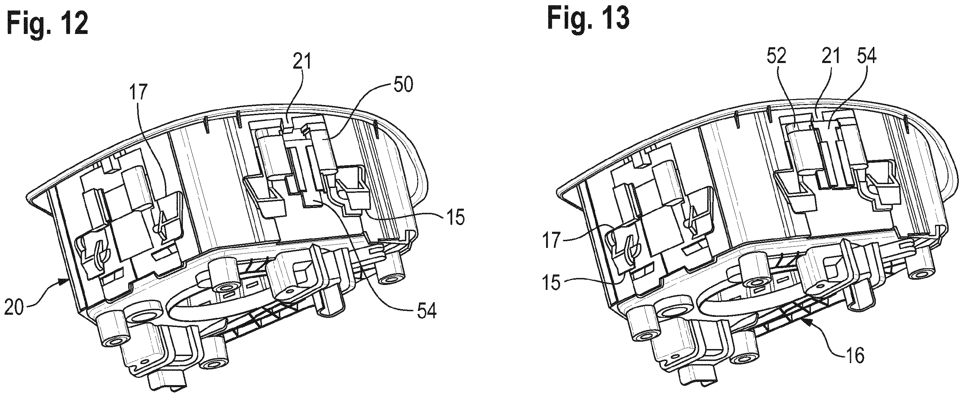

Bei einer abgewandelten Ausführungsform kann der Schlitten 52 mit einer an ihm ausgebildeten Druckfläche 52' im zusammengebauten Zustand lediglich in Berührkontakt mit einer entsprechenden Gegendruckstelle 21 der Abdeckung 20 stehen, wie in Figur 13 gezeigt. Die Gegendruckstelle 21 ist in der gezeigten Ausführung als fingerartiger Fortsatz an der Unterseite der Abdeckung bzw. in einer Aussparung der Wandung der Abdeckung 20 ausgebildet.

Um Geräusche zu minimieren, kann ferner vorgesehen sein, dass die Gegendruckstelle 21 der Abdeckung 20 und die Druckfläche 52' des Schlittens nur im Auslösefall mir einander in Kontakt stehen.

Es kann also vorgesehen sein, dass die Gegendruckstelle 21 der Abdeckung 20 und die Druckfläche 52' des Schlittens im Ruhezustand voneinander beabstandet angeordnet sind.

Der im Rahmen 50 bewegliche Schlitten 52 kann ein Lager für die Abdeckung 20 bilden, vorzugsweise ist die Abdeckung 20 jedoch an dem mit Airbagmodul-Gehäuse 14 direkt (in F-Richtung verschieblich) gelagert. Hierzu dienen insbesondere an den seitlichen Wänden des Airbagmodul-Gehäuses 14 ausgebildete Gehäusehaken 15, die beim Zusammenfügen von Airbagmodul-Gehäuse 14 und Abdeckung 20 in an den seitlichen Wänden der Abdeckung 20 ausgebildete Ausnehmungen 17 eingreifen bzw. einrasten und eine Art Führung von Gehäuse 14 und Abdeckung 20 zueinander bilden, wie in den Figuren 12 und 13 gezeigt.

Um das Eingreifen bzw. Einrasten der Gehäusehaken 15 in die Ausnehmungen 17 zu ermöglichen, muss die Abdeckung 20 relativ zum Gehäuse 14 weiter in F-Richtung verlagert werden, als dies im zusammengefügten Zustand nötig ist, um das Hornsignal auszulösen.

Insbesondere, um bei dieser Verlagerung eine Kollision zwischen Gegendruckstelle 21 der Abdeckung 20 und der am Schlitten 52 ausgebildeten Druckfläche 52' zu verhindern, kann erfindungsgemäß vorgesehen sein, dass der Teil der Druckfläche 52`, der tatsächlich in Kontakt mit Gegendruckstelle 21 der Abdeckung 20 gelangt, als gesondertes Schlittenteil 54 ausgebildet ist.

Dieses Schlittenteil 54 ist insbesondere verschiebbar entlang der F-Richtung in dem Schlitten 52 geführt.

Dieses Schlittenteil 54 ist insbesondere mit dem Schlitten 52 fixierbar, insbesondere verrastbar ausgebildet.

Auf diese Weise kann während des Zusammenfügens des Moduls die Abdeckung 20 auf das Gehäuse 14 aufgesteckt werden, so dass Gehäusehaken 15 Ausnehmungen 17 eingreifen bzw. einrasten und in einem weiteren Fügeschritt das Schlittenteil 54 aus einer (versenkten) Fügeposition relativ zum Schlitten 52 in eine Funktionsposition verschoben und dieser mit dem Schlitten 52 (der der Abdeckung 20) gekoppelt, insbesondere verrastet werden. Hierdurch ist eine Ausrichtung zur Gegendruckstelle 21 der Abdeckung 20 möglich, so dass im Aktivierungsfall ein Niederdrücken der Abdeckung 20 eine Relativbewegung der Messelektrode 12 zur die Kondensatorelektrode 22 erzeugt.

Das Hupenmodul ist also so ausgelegt, dass der Schlitten 52 vom Fahrer aus einer Ausgangsposition gegen den Widerstand der Federelemente 56 um eine definierte Wegstrecke entlang der Verschieberichtung F niederdrückbar ist. Die Federelemente 56 sorgen für eine automatische Rückstellung der Abdeckung 20 in deren Ausgangsposition, sobald der Fahrer die Abdeckung 20 nicht mehr niederdrückt.

Die am Schlitten 52 angebrachte Kondensatorelektrode 22 liegt der am Rahmen 50 angebrachten Messelektrode 12 in geringem Abstand gegenüber. Bevorzugt sind die Kondensatorelektrode 22 und die Sensorfläche 28 relativ zueinander so angeordnet, dass sie sich bei maximal niedergedrückter Abdeckung 20 bzw. bei maximal niedergedrücktem Schlitten 52 maximal überlappen.

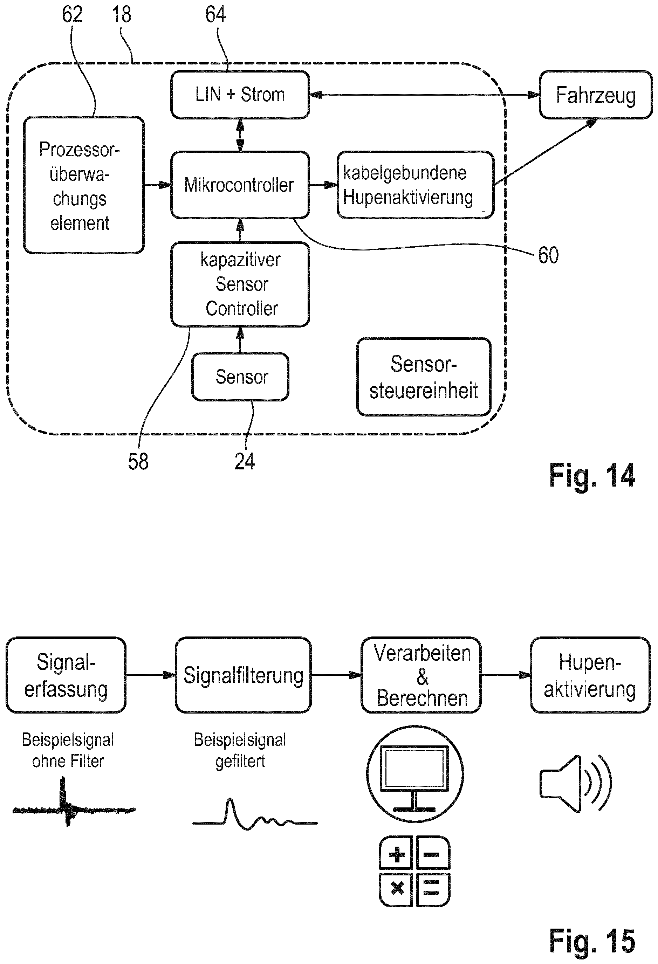

In Figur 14 ist beispielhaft eine Möglichkeit dargestellt, mit welchen elektronischen Komponenten die Elektronikeinheit (Elektronische Hupensensor-Kontrolleinheit) 18 des Hupenmoduls 10 realisiert werden kann. Gemäß dieser beispielhaften Konfiguration umfasst die Elektronikeinheit 18 einen mit der Messelektrode 12 der kapazitiven Sensoreinheit 24 verbundenen Kapazität/Digital-Wandler 58, der wiederum mit einem Mikrocontroller 60 verbunden ist. Der Mikrocontroller 60 steht mit einem Prozessorüberwachungselement 62 (Voltage Monitor + Watchdog) und mit einem LIN-Transceiver 64 mit integriertem Spannungsregler für die Datenkommunikation im Fahrzeug in Verbindung.

Der in dieser Konfiguration eingesetzte Kapazität/Digital-Wandler 58 verwendet einen LC-Schwingkreis zur Bestimmung einer Kapazitätsänderung, die als Verschiebung der Resonanzfrequenz des Schwingkreises beobachtet wird. Die gemessene Schwingungsfrequenz wird als digitaler Wert ausgegeben, der proportional zur Frequenz ist. Diese Frequenzmessung kann in eine äquivalente Kapazität umgewandelt werden. Im Mikrocontroller 60 werden die vom Kapazität/Digital-Wandler 58 gelieferten Werte weiterverarbeitet und ausgewertet. Abhängig von der Auswertung wird dann gegebenenfalls ein Hupsignal in einer Signalerzeugungseinheit 59 (Wired Activation Horn) erzeugt bzw. ausgelöst, um die Signalabgabeeinheit (Hupe) zu aktivieren.

Figur 15 fasst noch einmal den prinzipiellen Weg von einem ersten Schritt der Signalerfassung (Signal Acquirement; siehe: Beispiel eines ungefilterten Signals) über einen weiteren Schritt der Signalfilterung (Filter Signal; siehe: Beispiel eines gefilterten Signals) hin zu einem Schritt der Auswertung des Signals durch (Computing & Calculation) und schließlich einem Schritt der auf der Auswertung basierenden Aktivierung der Fahrzeughupe (Horn Activation) zusammen.

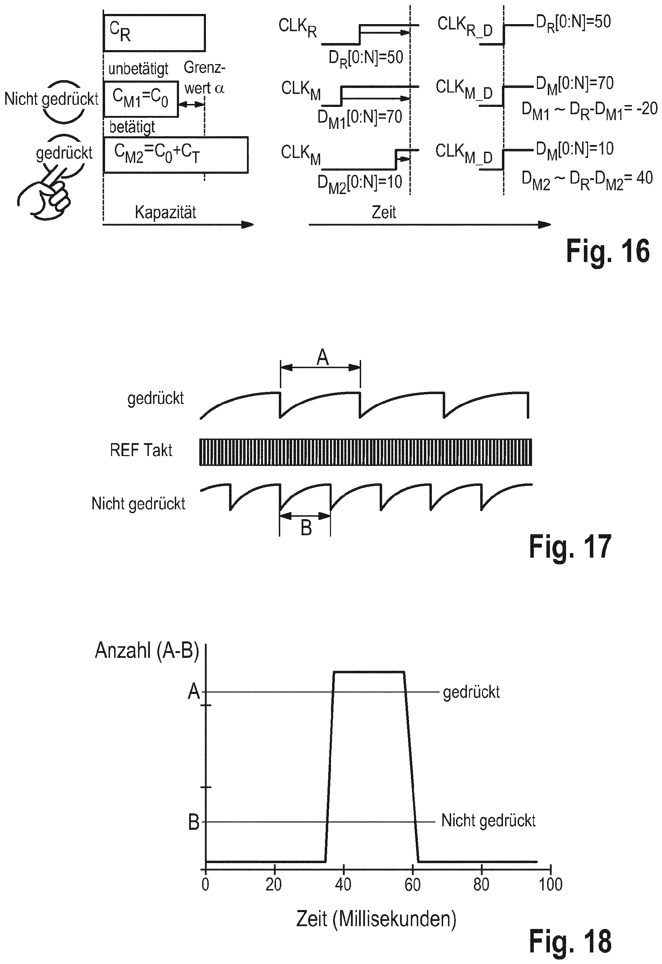

Nachfolgend wird unter Bezugnahme auf die Figuren 16 bis 18 ein grundlegendes Signalauswertungsprinzip, das auf einer Zählung von Takten und einem Vergleich mit einem Referenzzählwert basiert, in Zusammenhang mit einem bevorzugten Messverfahren beschrieben.

Einfach ausgerückt, wird eine ermittelte Kapazität (oder Kapazitätsänderung) in einen Zählwert umgewandelt, der dann die Basis für die Entscheidung bildet, ob die Hupeinrichtung aktiviert (gedrückt) ist, und demzufolge ein Hupsignal ausgegeben werden soll, oder nicht.

Wie bereits erläutert ändert sich die Kapazität des durch die beiden Elektroden 12, 22, genauer gesagt durch die Kondensatorelektrode 22 und die Sensorfläche 28 der Messelektrode 12, gebildeten Kondensators, wenn die Abdeckung 20 vom Fahrer niedergedrückt wird. Gemäß der bevorzugten Ausführungsform erhöht sich die Kapazität durch das Niederdrücken, da sich die Überlappung, d. h. der Bereich einander gegenüberliegender Flächen der Kondensatorelektrode 22 und der Messelektrode 12 vergrößert. (Natürlich ist auch die umgekehrte Variante möglich, bei der sich die Kapazität durch das Niederdrücken der Abdeckung 20 verringert.) In der Figur 16 sind die unterschiedlichen Kapazitäten bei nicht niedergedrückter bzw. bei niedergedrückter Abdeckung im Vergleich zu einer Referenzkapazität C_{R} dargestellt. Im ersten Fall ist die Kapazität kleiner, im zweiten Fall größer als die Referenzkapazität C_{R}.

Die Kapazitätsänderung wird gemäß dem bevorzugten Messverfahren folgendermaßen detektiert. In einem sich kontinuierlich wiederholenden Prozess lädt eine Konstantstromquelle den Kondensator auf. Hierzu wird die entsprechende Leitung 36 des Sensorgürtels 32 verwendet, der die Messelektrode 12 mit der Elektronikeinheit 18 verbindet. Gleichzeitig wird der Abschirmrahmen 30 aktiv auf ein vorgegebenes Abschirmpotential gelegt, oder er liegt auf Masse. Während des Aufladens des Kondensators zählt ein Zähler die Systemtakte. Ein Komparator vergleicht die Kondensatorspannung fortwährend mit einem Referenzschwellenwert REF. Sobald die Kondensatorspannung den Referenzschwellenwert REF erreicht, gibt der Komparator einen hohen Spannungspegel (High-Pegel) aus. Der hohe Spannungspegel sorgt dafür, dass ein Schalter einer Entladungsschaltung geschlossen wird, wodurch der Kondensator entladen wird. Der Zähler wird zurückgesetzt und der Prozess wiederholt.

Je größer die Kapazität des Kondensators, desto länger dauert das Aufladen, d. h. desto mehr Takte werden gezählt, bis der Referenzschwellenwert REF erreicht wird. Dies ist beispielhaft in Figur 17 durch den unterschiedlichen Spannungsverlauf bei zwei unterschiedlich langen Aufladezeiten A und B dargestellt. Die Bestimmung, ob der Fahrer die Abdeckung 20 niedergedrückt (pressed) oder nicht niedergedrückt (not pressed) hat mit der Absicht, ein Hupsignal auszulösen, erfolgt deshalb durch Zählen der Anzahl der (z.B. von einem Referenztaktgeber (REF clock) ausgegebenen) Takte, die für das Aufladen des Kondensators bis zum Referenzschwellenwert benötigt werden. Diese Anzahl wird mit einem voreingestellten Referenzzählwert verglichen (siehe Figur 14). Wenn die Anzahl der benötigten Takte größer als der Referenzzählwert ist, lässt dies bei der bevorzugten Ausführungsform auf ein Niederdrücken der Abdeckung 20 schließen (siehe Figur 18). Um die Detektion robust und störunanfällig zu machen, ist als (zusätzliches) Kriterium vorgesehen, dass ein Überschreiten (oder ein Unterschreiten) des Referenzzählwerts über eine vorgegebene Anzahl (oder einen Vergleichswert), (Counts A-B) von Takten (Zeitdauer etwa im Millisekundenbereich) vorliegen muss, bevor das Hupsignal letztlich ausgelöst wird.

Abhängig vom konkreten Design und der Präzision der kapazitiven Sensoreinheiten 24 sowie der Genauigkeit der Signalauswertung kann die Empfindlichkeit der Sensoreinheiten 24 ausreichen, um eine kleine Verschiebung der Abdeckung 20 in Richtung der Lenkradachse von bis zu weniger als 1 mm zuverlässig zu erfassen.

### Bezugszeichenliste

- 10: Hupenmodul
- 12: erste Elektrode (Messelektrode)
- 14: Airbagmodul-Gehäuse
- 15: Gehäusehaken
- 16: Fahrer-Airbagmodul
- 17: Ausnehmungen
- 18: Elektronikeinheit
- 20: Abdeckung
- 21: Gegendruckstelle
- 22: zweite Elektrode (Kondensatorelektrode)
- 24: kapazitive Sensoreinheit
- 26: Träger
- 28: Sensorfläche
- 30: Abschirmrahmen
- 32: Sensorgürtel
- 34: flexibles Band
- 36: elektrische Leitung
- 38: Kontaktstellen
- 40: Nullkraftsockel
- 42: Leiterplatte
- 44: Baugruppe
- 46: Mutter
- 48: Schraubbolzen
- 50: Rahmen
- 52: Schlitten
- 54: Schlittenteil
- 56: Federelemente
- 58: Kapazität/Digital-Wandler
- 59: Signalerzeugungseinheit
- 60: Mikrocontroller
- 62: Prozessorüberwachungselement
- 64: LIN-Transceiver
- F: Verschieberichtung
- C_{R}: Referenzkapazität
- REF: Referenzschwellenwert
- A, B: Aufladezeiten

## Patentansprüche

1. Hupenmodul (10) für ein Fahrzeuglenkrad, mit
wenigstens einer kapazitiven Sensoreinheit (24) zur Erfassung einer Hupenbetätigung sowie
einer Elektronikeinheit (18) zur Signalverarbeitung und -auswertung und zur Auslösung eines Hupsignals,
**dadurch gekennzeichnet, dass** die kapazitive Sensoreinheit (24) einen Rahmen (50) und einen im Rahmen (50) verschiebbar gelagerten Schlitten (52) aufweist, welcher an einem Auslöseelement angebracht ist,
wobei die kapazitive Sensoreinheit (24) eine erste Elektrode und eine gegenüberliegende zweite Elektrode aufweist, die durch Betätigung des Auslöseelements in einer Verschieberichtung (F) so relativ zueinander verschiebbar sind, dass sich dadurch das Ausmaß der Überlappung der Elektroden (12, 22) verändert,
wobei die erste Elektrode (12) am Rahmen (50) und die zweite Elektrode (22) am Schlitten (52) angebracht ist.

2. Hupenmodul (10) nach Anspruch 1, **dadurch gekennzeichnet, dass** die beiden Elektroden (12, 22) einander gegenüberliegende Flächen haben, die parallel zur Verschieberichtung (F) orientiert sind, wobei vorzugsweise bei einer Verschiebung der Elektroden (12, 22) der Abstand der Flächen in einer zur Verschieberichtung (F) senkrechten Richtung gleich bleibt.

3. Hupenmodul (10) nach Anspruch 1 oder 2, **dadurch gekennzeichnet, dass** ein vom Auslöseelement zurücklegbarer Verschiebeweg begrenzt ist, und dass die Elektroden (12, 22) relativ zueinander so angeordnet sind, dass sie sich bei maximaler Verschiebung maximal überlappen.

4. Hupenmodul (10) nach einem der vorhergehenden Ansprüche, **dadurch gekennzeichnet, dass** wenigstens die erste Elektrode (12) mit der Elektronikeinheit (18) verbunden ist.

5. Hupenmodul (10) nach Anspruch 4, **dadurch gekennzeichnet, dass** die erste Elektrode (12) im Wesentlichen plattenförmig ausgebildet ist und eine elektrisch leitende Sensorfläche (28) aufweist, die von einem elektrisch leitenden Abschirmrahmen (30) umgeben ist.

6. Hupenmodul (10) nach Anspruch 5, **dadurch gekennzeichnet, dass** die Sensorfläche (28) und der Abschirmrahmen (30) auf einem nicht leitfähigen Träger (26) aufgebracht sind.

7. Hupenmodul (10) nach einem der vorhergehenden Ansprüche, **dadurch gekennzeichnet, dass** mehrere, insbesondere drei oder vier, voneinander beabstandete kapazitive Sensoreinheiten (24) vorgesehen sind.

8. Hupenmodul (10) nach Anspruch 7, **dadurch gekennzeichnet, dass** die kapazitiven Sensoreinheiten (24) aus Sicht des Fahrers bezogen auf die Verschieberichtung (F) in der 3-Uhr, 6-Uhr und 9-Uhr-Position angeordnet sind.

9. Hupenmodul (10) nach Anspruch 7 oder 8, **dadurch gekennzeichnet, dass** die ersten Elektroden (12) der kapazitiven Sensoreinheiten (24) über wenigstens ein flexibles Band (34), das mehrere elektrische Leitungen (36) trägt, mechanisch miteinander verbunden sind.

10. Hupenmodul (10) nach Anspruch 9, **dadurch gekennzeichnet, dass** die elektrischen Leitungen (36) des flexiblen Bands (34) eine elektrische Verbindung zwischen den Sensorflächen (28) der ersten Elektroden (12) und der Elektronikeinheit (18) sowie vorzugsweise auch zwischen den Abschirmrahmen (30) und der Elektronikeinheit (18) herstellen.

11. Hupenmodul (10) nach einem der vorhergehenden Ansprüche, **dadurch gekennzeichnet, dass** die Elektronikeinheit (18) wenigstens einen mit der kapazitiven Sensoreinheit (24) verbundenen Kapazität/-Digital-Wandler (58) und einen Mikrocontroller (60) zur Auswertung der vom Kapazität/-Digital-Wandler (58) ausgegebenen Werte aufweist, wobei vorzugsweise der Mikrocontroller (60) noch mit einem Prozessorüberwachungselement (62) und einem LIN-Transceiver (64) mit integriertem Spannungsregler verbunden ist.

12. Hupenmodul (10) nach einem der vorhergehenden Ansprüche, **dadurch gekennzeichnet, dass** die Elektronikeinheit (18) zur Durchführung eines Auswertungsverfahrens eingerichtet ist, das auf einer Zählung von Takten und einem Vergleich mit einem Referenzzählwert basiert.

13. Hupenmodul (10) nach Anspruch 12, **dadurch gekennzeichnet, dass** die Elektronikeinheit (18) eine mit wenigstens einer der Elektroden (12, 22) verbundene Konstantstromquelle zum Aufladen eines durch die Elektroden (12, 22) gebildeten Kondensators, einen Zähler zum Zählen von Takten, einen Komparator zum Vergleichen der Kondensatorspannung mit einem Referenzschwellenwert (REF), einen durch den Ausgangspegel des Komparators steuerbaren Schalter zum Entladen des Kondensators und einen Speicher mit einem hinterlegten Referenzzählwert aufweist.

14. Hupenmodul (10) nach Anspruch 13, **dadurch gekennzeichnet, dass** die Elektronikeinheit (18) so eingerichtet ist, dass in einem kontinuierlich wiederholten Prozess die Konstantstromquelle den Kondensator auflädt, der Komparator die Kondensatorspannung fortwährend mit einem Referenzschwellenwert (REF) vergleicht, ein Zähler die Takte bis zum Erreichen des Referenzschwellenwerts (REF) zählt, bei Erreichen des Referenzschwellenwerts (REF) der Schalter einen Schaltkreis zum Entladen des Kondensators schließt und der Zähler zurückgesetzt wird.

15. Hupenmodul (10) nach Anspruch 14, **dadurch gekennzeichnet, dass** die Elektronikeinheit (18) so eingerichtet ist, dass die Anzahl der bis zum Erreichen des Referenzschwellenwerts (REF) benötigten Takte mit einem hinterlegten Referenzzählwert verglichen wird, wobei bei einem Überschreiten oder Unterschreiten des Referenzzählwerts ein Hupsignal ausgelöst wird.

16. Baugruppe (44) für ein Fahrzeuglenkrad, mit einem Fahrer-Airbagmodul (16) und einem daran angebrachten Hupenmodul (10) nach einem der vorhergehenden Ansprüche.

17. Baugruppe (44) nach Anspruch 16, **dadurch gekennzeichnet, dass** die erste Elektrode (12) an einem Gehäuse (14) des Fahrer-Airbagmoduls (16) und die zweite Elektrode (22) an einer als Auslöseelement dienenden verschiebbaren Abdeckung (20) des Fahrer-Airbagmoduls (16) angebracht ist.

18. Baugruppe (44) nach Anspruch 17, **dadurch gekennzeichnet, dass** eine Druckfläche (52') des Schlittens und eine Gegendruckstelle (21) der Abdeckung (20) nur im Auslösefall miteinander in Kontakt stehen und/oder dass die Gegendruckstelle (21) der Abdeckung (20) und die Druckfläche (52') des Schlittens im Ruhezustand voneinander beabstandet angeordnet sind.

19. Baugruppe (44) nach Anspruch 17 oder 18, **dadurch gekennzeichnet, dass** die erste Elektrode (12) an einer im Wesentlichen parallel zur Verschieberichtung (F) verlaufenden Seitenwand des Airbagmodul-Gehäuses (14) angebracht ist.

20. Baugruppe (44) nach einem der Ansprüche 17 bis 19, **dadurch gekennzeichnet, dass** die zweite Elektrode (22) an einer im Wesentlichen parallel zur Verschieberichtung (F) verlaufenden Seitenwand der Abdeckung (20) angebracht ist.

21. Baugruppe (44) nach einem der Ansprüche 17 bis 20, **dadurch gekennzeichnet, dass** der Rahmen (50) am Airbagmodul-Gehäuse (14) angebracht ist und/oder der Schlitten (52) in Berührkontakt, insbesondere in Druckkontakt, zu der Abdeckung (20) steht.

22. Baugruppe (44) nach einem der Ansprüche 17 bis 21, **dadurch gekennzeichnet, dass** der im Rahmen (50) verschiebbare Schlitten (52) zusammen mit wenigstens einem Federelement (56) ein Lager für die Abdeckung (20) bildet, sodass die Abdeckung (20) gegen den Widerstand des Federelements (56) niedergedrückt werden kann.

23. Baugruppe (44) nach einem der Ansprüche 17 bis 22, **dadurch gekennzeichnet, dass** die Elektronikeinheit (18) des Hupenmoduls (10) am Fahrer-Airbagmodul (16) angebracht ist, insbesondere auf einer vom Fahrer abgewandten Unterseite des Airbagmodul-Gehäuses (14).

24. Baugruppe (44) nach Anspruch 23, **dadurch gekennzeichnet, dass** zur Befestigung der Elektronikeinheit (18) dieselben Befestigungsmittel wie für die Befestigung einer Airbag-Einheit im Airbagmodul-Gehäuse (14) vorgesehen sind.

25. Baugruppe (44) nach einem der Ansprüche 17 bis Anspruch 24, **dadurch gekennzeichnet, dass** eine Druckfläche (54') des Schlittens (52), die im Auslösefall mit einer Gegendruckstelle (21) der Abdeckung (20) in Kontakt steht, zumindest zur Montage von Abdeckung (20) und Airbagmodul-Gehäuse (16) relativ beweglich zum Schlitten (52) ausgebildet ist.

26. Lenkrad mit einem daran angebrachten Hupenmodul (10) nach einem der Ansprüche 1 bis 16.

## Claims

1. A horn module (10) for a vehicle steering wheel, comprising
at least one capacitive sensor unit (24) for detecting a horn actuation as well as
an electronic unit (18) for signal processing and evaluation and for triggering a horn signal,
**characterized in that** the capacitive sensor unit (24) includes a frame (50) and a slide (52) movably supported in the frame (50) which slide is arranged on a trigger element,
wherein the capacitive sensor unit (24) includes a first electrode and an opposite second electrode which are movable relative to each other in a displacing direction (F) by actuation of the trigger element so that in this way the extent of overlapping of the electrodes (12, 22) will vary,
wherein the first electrode (12) is arranged on the frame (50) and the second electrode (22) on the slide (52).

2. The horn module (10) according to claim 1, **characterized in that** the two electrodes (12, 22) have surfaces facing each other which are oriented in parallel to the displacing direction (F), wherein preferably during displacement of the electrodes (12, 22) the distance of the surfaces remains constant in a vertical direction to the displacing direction (F).

3. The horn module (10) according to claim 1 or 2, **characterized in that** a displacing distance to be covered by the trigger element is limited and **in that** the electrodes (12, 22) are arranged relative to each other so that they are maximally overlapping in the case of maximum displacement.

4. The horn module (10) according to any one of the preceding claims, **characterized in that** at least the first electrode (12) is connected to the electronic unit (18).

5. The horn module (10) according to claim 4, **characterized in that** the first electrode (12) is substantially plate-shaped and includes an electrically conducting sensor surface (28) which is surrounded by an electrically conducting shielding frame (30).

6. The horn module (10) according to claim 5, **characterized in that** the sensor surface (28) and the shielding frame (30) are applied to a non-conductive support (26).

7. The horn module (10) according to any one of the preceding claims, **characterized in that** plural, especially three or four, capacitive sensor units (24) spaced apart from each other are provided.

8. The horn module (10) according to claim 7, **characterized in that** the capacitive sensor units (24) are arranged, when viewed by the driver, relative to the displacing direction (F) at the 3 o'clock, 6 o'clock and 9 o'clock position.

9. The horn module (10) according to claim 7 or 8, **characterized in that** the first electrodes (12) of the capacitive sensor units (24) are mechanically interconnected via at least one flexible strap (34) supporting plural electric lines (36).

10. The horn module (10) according to claim 9, **characterized in that** the electric lines (36) of the flexible strap (34) establish an electric connection between the sensor surfaces (28) of the first electrodes (12) and the electronic unit (18) as well as preferably also between the shielding frames (30) and the electronic unit (18).

11. The horn module (10) according to any one of the preceding claims, **characterized in that** the electronic unit (18) includes at least one capacity/digital converter (58) connected to the capacitive sensor unit (24) and a micro-controller (60) for evaluating the values output by the capacity/digital converter (58), wherein preferably the micro-controller (60) is further connected to a processor monitoring element (62) and a LIN transceiver (64) having an integrated voltage regulator.

12. The horn module (10) according to any one of the preceding claims, **characterized in that** the electronic unit (18) is arranged for performing an evaluating process based on a counting of clocks and a comparison with a reference count.

13. The horn module (10) according to claim 12, **characterized in that** the electronic unit (18) includes a constant power source connected to at least one of the electrodes (12, 22) for charging a capacitor formed by the electrodes (12, 22), a counter for counting clocks, a comparator for comparing the capacitor voltage to a reference threshold (REF), a switch controllable by the output level of the comparator for discharging the capacitor and a memory comprising a deposited reference count.

14. The horn module (10) according to claim 13, **characterized in that** the electronic unit (18) is arranged so that in a continuously repeated process the constant power source charges the capacitor, the comparator continuously compares the capacitor voltage to a reference threshold (REF), a counter counts the clocks until the reference threshold (REF) is reached, upon reaching the reference threshold (REF) the switch closes a circuit for discharging the capacitor and the counter is reset.

15. The horn module (10) according to claim 14, **characterized in that** the electronic unit (18) is arranged so that the number of the clocks required until the reference threshold (REF) is reached is compared to a deposited reference count, wherein upon exceeding or going below the reference count, a horn signal is triggered.

16. A subassembly (44) for a vehicle steering wheel, comprising a driver airbag module (16) and a horn module (10) attached thereto according to any one of the preceding claims.

17. The subassembly (44) according to claim 16, **characterized in that** the first electrode (12) is arranged on a housing (14) of the driver airbag module (16) and the second electrode (22) is arranged on a movable cover (20) of the driver airbag module (16) serving as a trigger element.

18. The subassembly (44) according to claim 17, **characterized in that** a contact surface (52') of the slide and a counterpressure position (21) of the cover (20) contact each other only in the trigger case and/or **in that** the counterpressure position (21) of the cover (20) and the contact surface (52') of the slide are arranged to be spaced apart from each other in the idle state.

19. The subassembly (44) according to claim 17 or 18, **characterized in that** the first electrode (12) is arranged on a sidewall of the airbag module housing (14) extending substantially in parallel to the displacing direction (F).

20. The subassembly (44) according to any one of the claims 17 to 19, **characterized in that** the second electrode (22) is arranged on a sidewall of the cover (20) extending substantially in parallel to the displacing direction (F).

21. The subassembly (44) according to any one of the claims 17 to 20, **characterized in that** the frame (50) is arranged on the airbag module housing (14) and/or the slide (52) is in contact, especially in pressure contact, with the cover (20).

22. The subassembly (44) according to any one of the claims 17 to 22, **characterized in that** the slide (52) movable within the frame (50) forms a bearing for the cover (20) together with at least one spring element (56) so that the cover (20) can be pressed down against the resistance of the spring element (56).

23. The subassembly (44) according to any one of the claims 17 to 22, **characterized in that** the electronic unit (18) of the horn module (10) is arranged on the driver airbag module (16), especially on a lower side of the airbag module housing (14) facing away from the driver.

24. The subassembly (44) according to claim 23, **characterized in that** for fastening the electronic unit (18) the same fasteners as for fastening an airbag unit within the airbag module housing (14) are provided.

25. The subassembly (44) according to any one of the claims 17 to 24, **characterized in that** a contact surface (54') of the slide (52) which in the trigger case is in contact with a counterpressure position (21) of the cover (20) is formed to be movable relative to the slide (52) at least for mounting the cover (20) and the airbag module housing (16).

26. A steering wheel comprising a horn module (10) attached thereto according to any one of the claims 1 to 16.

## Revendications

1. Module d'avertisseur sonore (10) pour un volant de véhicule, comprenant
au moins une unité de détection capacitive (24) pour détecter l'actionnement de l'avertisseur sonore ainsi que
une unité électronique (18) pour le traitement et l'évaluation du signal et pour le déclenchement d'un signal de l'avertisseur sonore,
**caractérisé en ce que** l'unité de capteur capacitif (24) présente un cadre (50) et un chariot (52) coulissant logé dans le cadre (50), lequel est monté sur un élément de déclenchement,
pour lequel l'unité de détection capacitive (24) présente une première électrode et une deuxième électrode opposée, lesquelles peuvent être déplacées l'une par rapport à l'autre dans une direction de déplacement (F) par actionnement de l'élément de déclenchement, de telle sorte que l'étendue du chevauchement des électrodes (12, 22) est ainsi modifiée,
pour lequel la première électrode (12) est montée sur le cadre (50) et la deuxième électrode (22) sur le chariot (52).

2. Module d'avertisseur sonore (10) selon la revendication 1, **caractérisé en ce que** les deux électrodes (12, 22) ont des faces opposées, lesquelles sont orientées parallèlement à la direction de déplacement (F), pour lequel de préférence lors d'un déplacement des électrodes (12, 22), la distance entre les faces reste la même dans une direction perpendiculaire à la direction de déplacement (F).

3. Module d'avertisseur sonore (10) selon la revendication 1 ou 2, **caractérisé en ce qu'**une course de déplacement pouvant être parcourue par l'élément de déclenchement est limitée, et **en ce que** les électrodes (12, 22) sont disposées l'une par rapport à l'autre de telle sorte qu'elles se chevauchent au maximum lors du déplacement maximal.

4. Module d'avertisseur sonore (10) selon l'une des revendications précédentes, **caractérisé en ce qu'**au moins la première électrode (12) est reliée à l'unité électronique (18).

5. Module d'avertisseur sonore (10) selon la revendication 4, **caractérisé en ce que** la première électrode (12) est réalisée essentiellement en forme de plaque et présente une surface de détection (28) conductrice de l'électricité, laquelle est entourée d'un cadre de blindage (30) conducteur de l'électricité.

6. Module d'avertisseur sonore (10) selon la revendication 5, **caractérisé en ce que** la surface de détection (28) et le cadre de blindage (30) sont appliqués sur un support non conducteur (26).

7. Module d'avertisseur sonore (10) selon l'une des revendications précédentes, **caractérisé en ce que** plusieurs, en particulier trois ou quatre, unités de capteurs capacitifs (24) espacées les unes par rapport aux autres sont prévues.

8. Module d'avertisseur sonore (10) selon la revendication 7, **caractérisé en ce que** les unités de capteurs capacitifs (24) sont disposées, du point de vue du conducteur, par rapport à la direction de déplacement (F), dans la position de 3 heures, de 6 heures et de 9 heures.

9. Module d'avertisseur sonore (10) selon la revendication 7 ou 8, **caractérisé en ce que** les premières électrodes (12) des unités de détection capacitives (24) sont reliées mécaniquement entre elles par au moins une bande flexible (34) portant plusieurs conducteurs électriques (36).

10. Module d'avertisseur sonore (10) selon la revendication 9, **caractérisé en ce que** les conducteurs électriques (36) de la bande flexible (34) établissent une connexion électrique entre les surfaces de détection (28) des premières électrodes (12) et l'unité électronique (18) et, de préférence, également entre le cadre de blindage (30) et l'unité électronique (18).

11. Module d'avertisseur sonore (10) selon l'une des revendications précédentes, **caractérisé en ce que** l'unité électronique (18) présente au moins un convertisseur capacitance vers numérique (58) relié à l'unité de détection capacitive (24) et un microcontrôleur (60) pour l'évaluation des valeurs émises par le convertisseur capacitance vers numérique (58),pour lequel le microcontrôleur (60) est de préférence encore relié à un élément de surveillance de processeur (62) et à un émetteur-récepteur LIN (64) avec régulateur de tension intégré.

12. Module d'avertisseur sonore (10) selon l'une des revendications précédentes, **caractérisé en ce que** l'unité électronique (18) est agencée pour mettre en oeuvre un procédé d'évaluation basé sur un comptage de cycles et une comparaison avec une valeur de comptage de référence.

13. Module d'avertisseur sonore (10) selon la revendication 12, **caractérisé en ce que** l'unité électronique (18) comporte une source de courant constant reliée à au moins l'une des électrodes (12, 22) pour charger un condensateur formé par les électrodes (12, 22), un compteur pour compter les cycles, un comparateur pour comparer la tension du condensateur à une valeur de seuil de référence (REF), un commutateur pouvant être commandé par le niveau de sortie du comparateur pour décharger le condensateur et une mémoire avec une valeur de comptage de référence mémorisée.

14. Module d'avertisseur sonore (10) selon la revendication 13, **caractérisé en ce que** l'unité électronique (18) est agencée de telle sorte que, dans un processus répété en continu, la source de courant constant charge le condensateur, le comparateur compare en permanence la tension du condensateur à une valeur de seuil de référence (REF), un compteur compte les cycles jusqu'à ce que soit atteinte la valeur de seuil de référence (REF), lorsque la valeur de seuil de référence (REF) est atteinte, le commutateur ferme un circuit pour décharger le condensateur et le compteur est remis à zéro.

15. Module d'avertisseur sonore (10) selon la revendication 14, **caractérisé en ce que** l'unité électronique (18) est agencée de telle sorte que le nombre de cycles nécessaires pour atteindre la valeur de seuil de référence (REF) est comparé à une valeur de comptage de référence mémorisée, pour lequel un signal d'avertisseur sonore sera déclenché pour une valeur de comptage de référence dépassée ou non atteinte.

16. Ensemble (44) pour volant de direction de véhicule, comprenant un module airbag conducteur (16) et un module d'avertisseur sonore (10) monté sur celui-ci, selon l'une quelconque des revendications précédentes.

17. Ensemble (44) selon la revendication 16, **caractérisé en ce que** la première électrode (12) est montée sur un boîtier (14) du module airbag conducteur (16) et la deuxième électrode (22) est montée sur un couvercle coulissant (20) du module airbag conducteur (16) servant d'élément de déclenchement.

18. Ensemble (44) selon la revendication 17, **caractérisé en ce qu'**une surface d'appui (52') du chariot et un point de contre-pression (21) du couvercle (20) ne sont en contact l'un avec l'autre qu'en cas de déclenchement et/ou **en ce que** le point de contre-pression (21) du couvercle (20) et la surface d'appui (52') du chariot sont disposés à une certaine distance l'un de l'autre à l'état de repos.

19. Ensemble (44) selon la revendication 17 ou 18, **caractérisé en ce que** la première électrode (12) est montée sur une paroi latérale du boîtier du module airbag (14) qui s'étend sensiblement parallèlement à la direction de déplacement (F).

20. Ensemble (44) selon l'une des revendications 17 à 19, **caractérisé en ce que** la deuxième électrode (22) est montée sur une paroi latérale du couvercle (20) sensiblement parallèle à la direction de déplacement (F).

21. Ensemble (44) selon l'une quelconque des revendications 17 à 20, **caractérisé en ce que** le cadre (50) est monté sur le boîtier (14) du module airbag et/ou le chariot (52) est en contact d'appui, notamment en contact de pression, avec le couvercle (20).

22. Ensemble (44) selon l'une quelconque des revendications 17 à 21, **caractérisé en ce que** le chariot (52) pouvant coulisser dans le cadre (50) forme, avec au moins un élément élastique (56), un palier pour le couvercle (20), de sorte que le couvercle (20) peut être enfoncé contre l'effort résistant de l'élément élastique (56).

23. Ensemble (44) selon l'une des revendications 17 à 22, **caractérisé en ce que** l'unité électronique (18) du module d'avertisseur sonore (10) est montée sur le module airbag conducteur (16), notamment sur une face inférieure du boîtier du module airbag (14) opposée au conducteur.

24. Ensemble (44) selon la revendication 23, **caractérisé en ce que** pour la fixation de l'unité électronique (18) sont prévus les mêmes moyens de fixation que pour la fixation d'une unité airbag dans le boîtier du module airbag (14).

25. Ensemble (44) selon l'une des revendications 17 à la revendication 24, **caractérisé en ce qu'**une surface d'appui (54') du chariot (52), laquelle est en contact avec un point de contre-pression (21) du couvercle (20) en cas de déclenchement, est réalisée mobile par rapport au chariot (52) au moins pour le montage du couvercle (20) et du boîtier du module airbag (16).

26. Volant de direction sur lequel est monté un module d'avertisseur sonore (10) selon l'une quelconque des revendications 1 à 16.
